Europäisches Patentamt

European Patent Office

Office européen des brevets

(19)

(11) Publication number : **0 529 969 A1**

## (12) EUROPEAN PATENT APPLICATION

(21) Application number : **92307657.4**

(22) Date of filing : **21.08.92**

(51) Int. Cl.⁵ : **G03F 7/023, C08G 8/24**

(30) Priority : **22.08.91 US 748472**

(43) Date of publication of application :
**03.03.93 Bulletin 93/09**

(84) Designated Contracting States :
**BE CH DE FR GB IT LI NL**

(71) Applicant : **HOECHST CELANESE CORPORATION**
**Route 202-206 North**
**Somerville, N.J. 08876 (US)**

(72) Inventor : **Khanna, Dinesh N.**
**4 Mulberry Court**
**East Greenwich, Rhode Island 02818 (US)**
Inventor : **Durham, Dana L.**
**3 Apple Tree Court**
**East Greenwich, Rhode Island 02818 (US)**

(74) Representative : **De Minvielle-Devaux, Ian Benedict Peter et al**
**CARPMAELS & RANSFORD 43, Bloomsbury Square**
**London WC1A 2RA (GB)**

(54) Novolak resin compositions with high Tg and high sensitivity for photoresist applications.

(57)    A water insoluble, aqueous alkali soluble novolak resin having a molecular of at least 5,000, process for producing such a novolak resin, a photoresist containing such a novolak resin, and a method for producing a semiconductor device, wherein the resin is obtained by condensing with formaldehyde a mixture of from about 30 to about 99 mol percent of meta-cresol, from about 1 to about 40 mol percent of 3,5-dimethylphenol or 3,5-xylenol.

EP 0 529 969 A1

Field of the Invention

The present invention relates to thermally stable phenolic resins and their use in light-sensitive compositions. The present invention also relates to light-sensitive compositions useful in positive-working photoresist compositions. Further, the present invention relates to substrates coated with these light-sensitive compositions as well as the process of coating, imaging and developing these light-sensitive mixtures on these substrates.

Background of the Invention

Photoresist compositions are used in microlithography processes for making miniaturized electronic components such as in the fabrication of computer chips and integrated circuits. Generally, in these processes, a thin coating of film of a photoresist composition is first applied to a substrate material, such as silicon wafers used for making integrated circuits. The coated substrate is then baked to evaporate any solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the coated surface of the substrate.

There are two types of photoresist compositions, negative-working and positive-working. When negative-working photoresist compositions are exposed image-wise to radiation, the areas of the resist composition exposed to the radiation become less soluble to a developer solution (e,g, a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying substrate surface is uncovered.

After this developmant operation, the now partially unprotected substrate may be treated with a substrate-etchant solution or plasma gases and the like. The etchant solution or plasma gases etch that portion of the substrate where the photoresist coating was removed during development. The areas of the substrate where the photoresist coating still remains are protected and, thus, an etched pattern is created in the substrate material which corresponds to the photomask used for the image-wise exposure of the radiation. Later, the remaining areas of the photoresist coating may be removed during a stripping operation, leaving a clean etched substrate surface. In some instances, it is desirable to heat treat the remaining photoresist layer, after the development step and before the etching step, to increase its adhesion to the underlying substrate and its resistance to etching solutions.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of one micron or less are necessary. In addition, it is almost always desirable that the developed photoresist wall profiles be near vertical relative to the substrate. Such demarcations between developed and undeveloped areas of the resist coating translate into accurate pattern transfer of the mask image onto the substrate.

One drawback with positive-working photoresists known in the prior art is their limited resistance to thermal image deformation. This limitation is becoming an increasing problem because modern processing techniques in semiconductor device manufacture require photoresist images which have higher image deformation temperatures. Past efforts to increase thermal stability (e.g. increased molecular weight) generally caused significant decrease in other desirable properties (e.g. decreased photospeed or diminished adhesion or reduced contrast).

Accordingly, there is a need for improved positive-working photoresist formulations which produce images that are resistant to thermal deformation at higher temperatures while maintaining the other desired properties (e.g. photospeed) at suitable levels.

## SUMMARY OF THE INVENTION

The present invention relates to high molecular weight thermally stable phenol formaldehyde resins and their use in photoresist compositions. The invention further relates to positive-working photoresists containing these phenol formaldehyde resins and a photosensitizer, and the use of such photoresists in producing semiconductor devices.

The invention provides water insoluble, aqueous alkali soluble novolak resin obtained by condensing with formaldehyde a mixture of from about 30 to about 99 mol percent of meta-cresol and from about 1 to about 50 mol percent of 3,5-dimethylphenol or 3,5-xylenol,having a molecular weight of at least about 5,000.

The novolak resin obtained has a fast, tailored photospeed and a high glass transition temperature (Tg) up to about 130°C. The hydroxy groups of the novolak may be partially esterified to provide a resin with good photospeed control and a Tg up to about 150°C. The novolaks obtained are extremely reproducible in terms of viscosity, dissolution rate and Tg, which is of the utmost importance for lithographic applications.

The water insoluble, aqueous alkali soluble novolak resin obtained by condensing with formaldehyde a mixture of from about 30 to about 99 mol percent of m-cresol and from about 1 to about 50 mol percent of 3,5-dimethylphenol or 3,5-xylenol and having a molecular weight of at least about 5,000 may have its hydroxy groups partially esterified by reacting from about 1 to about 10 percent of the hydroxy groups with an organic acid group containing compound. The organic acid group containing compounds are preferably organic chlorides such as sulfonyl chlorides including 4-chloro sulfonyl chloride, 4-methane sulfonyl chloride, paratoluene sulfonyl chloride, trifluoromethane sulfonyl chloride, 1,2-napthoquinone diazide-4-sulfonyl chloride, 1,2-napthoquinone diazide-5-sulfonyl chloride; para-anisoyl chloride, acetyl chloride and benzoyl chloride.

The invention also provides a positive photoresist composition consisting essentially of an admixture of:
 a) a photosensitive component in an amount sufficient to uniformly photosensitize the photoresist composition; and
 b) a water insoluble, aqueous alkali soluble novolak resin obtained by condensing with formaldehyde a mixture of from about 30 to about 99 mol percent of meta-cresol and from about 1 to about 50 mol percent of 3,5-dimethylphenol or 3,5-xylenol and having a molecular weight of at least about 5,000, preferably from about 5,000 to 20,000, the novolak resin being present in the photoresist composition in an amount sufficient to form a substantially uniform photoresist composition; and
 c) a suitable solvent.

The insoluble, aqueous alkali soluble novolak resin obtained by condensing with formaldehyde a mixture of from about 30 to about 99 mol percent of m-cresol, from about 1 to about 50 mol percent of 3,5-dimethylphenol or 3,5-xylenol and having a molecular weight of at least about 5,000 may have its hydroxy groups partially esterified by reacting from about 1 to about 10 percent of the hydroxy groups with an organic acid group containing compound.

The invention further provides a method for producing a semiconductor device by producing a photoresist image on a substrate by coating a suitable substrate with a positive working photoresist composition which composition consists essentially of an admixture of:
 a) a photosensitive component in an amount sufficient to photosensitize the photoresist composition; and
 b) a water insoluble, aqueous alkali soluble novolak resin obtained by condensing with formaldehyde a mixture of from about 30 to about 99 mol percent of meta-cresol and from about 1 to about 50 mol percent of 3,5-dimethylphenol or 3,5-xylenol and having a molecular weight of at least about 5,000, wherein the novolak resin may have its hydroxy groups partially esterified by reacting from about 1 to about 10 of the hydroxy groups with an organic acid group containing compound, the novolak resin being present in the photoresist composition in an amount sufficient to form a substantially uniform photoresist composition; and
 c) a suitable solvent; and
 d) heat treating the coated substrate until substantially all of the solvent is removed; image-wise exposing the photosensitive composition; and removing the image-wise exposed areas of such composition with an aqueous alkaline developer. Optionally one may perform a baking of the substrate either immediately before or after the removing step.

## DETAILED DESCRIPTION OF THE PREFERRED EMBODIMENT

In the production of the relief image of the present invention, one coats and dries the foregoing photoresist composition on a suitable substrate.

Novolak resins have been commonly used in the art of photoresist manufacture as exemplified by "Chemistry and Application of Phenolic Resins", Knop A. An Scheib, W.; Springer Verlag, New york, 1979 in Chapter 4. Similarly, o-quinone diazides are well known to the skilled artisan as demonstrated by "Light Sensitive Systems", Kosar, J.; John Wiley & Sons, New york, 1965 Chapter 7.4. However, the instant invention has found that the use of particular novolak resins, as opposed to those taught in the prior art, produces a photoresist having high thermal stability.

The particular novolak resins employed by this invention are water insoluble, aqueous alkali soluble resin obtained by condensing with formaldehyde a mixture of from about 30 to about 99 mol percent of m-cresol and from about 1 to about 50 mol percent of 3,5-dimethylphenol or 3,5-xylenol, and having a molecular weight of at least about 5,000, preferably from about 5,000 to 20,000.

More preferably, it is obtained by condensing with formaldehyde a mixture of from about 30 to about 80 mol percent of m-cresol and from about 1 to about 50 mol percent of 3,5-dimethylphenol or 3,5-xylenol, and has a molecular weight of from about 5,000 to 20,000.

The condensation may be conducted by forming an admixture of the m-cresol and 3,5-dimethylphenol or 3,5-xylenol and a catalytic amount of acid, and heating the mixture at from about 25°C to about 95°C with agitation. To the heated mixture is added an aqueous solution of formaldehyde, such as for example a 0.70 mole % to about 0.85 mole % aqueous solution. This latter solution may be added to the former over the course of about 1/2 hour to about 2 hours. The mixture is allowed to react to completion for about 4 hours to about 6 hours at about 95°C to about 100°C.

The sensitizer which comprises a component of the photoresist composition of the present invention may be an ester of a multihydroxy phonolic or alcoholic compound preferably hydroxybenzophenone and a sulfonic acid, such as described in U.S. Patents 3,106,465 and 4,719,167, which are incorporated herein by reference.

The photoresist composition is formed by blending the ingredients in a suitable solvent. In the preferred embodiment, the amount of novolak in the photoresist preferably ranges from 12% to about 25% and more preferably from about 10% to about 20% based on the weight of the solid; i,e., non-solvent photoresist components. In the preferred embodiment, the photosensitizer is present in the photoresist in an amount of from about 1% to about 6% preferably from about 3% to about 5% based on the weight of the solid photoresist components. In producing the photoresist composition, the novolak and sensitizer are mixed with such solvents as propylene glycol mono-alkyl ether, propylene glycol alkyl ether acetate, butyl acetate, xylene, ethylene glycol monoethyl ether acetate, and most preferably propylene glycol monomethyl ether acetate, among others.

Other optional ingredients such as colorants, dyes, antistriation agents, leveling agents, plasticizers, adhesion promoters, speed enhancers, solvents and such surfactants as nonionic surfactants may be added to the solution of novolak resin, sensitizer and solvent before the solution is coated onto a substrate. Examples of dye additives that may be used together with the photoresist compositions of the present invention include Methyl violet 2B (C.I. No. 42535), Crystal violet (C.I. 42555). Malachite Green (C.I. No. 42000), victoria Blue B (C.I. No. 44045) and Neutral Red (C.I. No. 50040) at one to ten percent weight levels, based on the combined weight of novolak and sensitizer. The dye additives help provide increased resolution by inhibiting back scattering of light off the substrate.

Anti-striation agents may be used at up to about a five percent weight level, based on the combined weight of novolak and sensitizer. Plasticizers which may be used include, for example, phosphoric acid tri-(beta-chloroethyl)-ester; stearic acid; dicamphor; polypropylene; acetal resins; phenoxy resins; and alkyl resins, at about one to ten percent weight levels, based on the combined weight of novolak and sensitizer. The plasticizer additives improve the coating properties of the material and enable the application of a film that is smooth and of uniform thickness to the substrate.

Adhesion promoters which may be used include, for example, beta-(3,4-epoxy-cyclohexyl)-ethyltrimethoxysilane; p-methyl-disilane-methyl methacrylate; vinyltrichlorosilane; and gamma-amino-propyl triethoxysilane up to about a 4 percent weight level, based on the combined weight of novolak and sensitizer. Development speed enhancers that may be used include, for example, picric acid, nicotinic acid or nitrocinnamic acid up to about a 20 percent weight level, based on the combined weight of novolak and sensitizer. These enhancers tend to increase the solubility of the photoresist coating in both the exposed and unexposed areas, and thus they are used in applications when speed of development is the overriding consideration even though some degree of contrast may be sacrificed; i.e., while the exposed areas of the photoresist coating will be dissolved more quickly by the developer, the speed enhancers will also cause a larger loss of photoresist coating from the unexposed areas.

The coating solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol; octylphenoxy ethanol at up to about 10% weight levels, based on the combined weight of novolak and sensitizer.

The prepared photoresist solution, can be applied to a substrate by any conventional method used in the photoresist art, including dipping, spraying, whirling and spin coating. When spin coating, for example, the resist solution can be adjusted with respect to the percentage of solids content, in order to provide coating of the desired thickness, given the type of spinning equipment utilized and the amount of time allowed for the spinning process. Suitable substrates include silicon, aluminum polymeric resins, silicon dioxide, doped silicon dioxide, silicon nitride, tantalum, copper, polysilicon, ceramics, aluminum/copper mixtures; gallium arsenide and other such Group III/V compounds.

The photoresist coatings produced by the described procedure are particularly suitable for application to thermally grown silicon/silicon dioxide-coated wafers, such as are utilized in the production of microprocessors and other miniaturized integrated circuit components. An aluminum/aluminum oxide wafer can also be used. The substrate may also comprise various polymeric resins, especially transparent polymers such as polyesters. The substrate may have an adhesion promoted layer of a suitable composition, such as one containing hexaalkyl disilazane.

The photoresist composition solution is then coated onto the substrate, and the substrate is treated at a temperature from about 70°C to about 110°C for from about 30 seconds to about 180 seconds on a hot plate from about 15 to about 90 minutes in a convection oven. This temperature treatment is selected in order to reduce the concentration of residual solvents in the photoresist, while not causing substantial thermal degradation of the photosensitizer. In general, one desires to minimize the concentration of solvents and this first temperature treatment is conducted until substantially all of the solvents have evaporated and a thin coating of photoresist composition, on the order of one micron in thickness, remains on the substrate. In a preferred embodiment the temperature is from about 85°C to about 95°C. The treatment is conducted until the rate of change of solvent removal becomes relatively insignificant. The temperature and time selection depends on the photoresist properties desired by the user, as well as the equipment used and commercially desired coating times. The coating substrate can then be exposed to actinic radiation, e.g., ultraviolet radiation, at a wavelength of from about 300 nm to about 450 nm, x-ray, electron beam, ion beam or laser radiation, in any desired pattern, produced by use of suitable masks, negatives, stencils, templates, etc.

The photoresist is then optionally subjected to a post exposure second baking or heat treatment either before or after development. The heating temperature may range from about 90°C to about 120°C, more preferably from about 100°C to about 110°C. The heating may be conducted for from about 30 seconds to about 2 minutes, more preferably from about 60 seconds to about 90 seconds on a hot plate or about 30 to about 45 minutes by convection oven.

The exposed photoresist-coated substrates are developed to remove the image-wise exposed areas by immersion in an alkaline developing solution or by spray puddle developer process. The solution is preferably agitated, for example, by nitrogen burst agitation. The substrates are allowed to remain in the developer until all, or substantially all, or the photoresist coating has dissolved from the exposed areas. Developers may include aqueous solutions of ammonium or alkali metal hydroxides. One preferred hydroxide in tetramethyl ammonium hydroxide. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silicon dioxide-type substrates, the developed substrates may be treated with a buffered, hydrofluoric acid base etching solution. The photoresist compositions of the present invention are resistant to acid-base etching solutions and provide effective protection for the unexposed photoresist-coating areas of the substrate.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

Example 1

Synthesis of Meta-Cresol/3,5-Dimethyl Phenol Formaldehyde Novolak Resin

Into a 500 ml. three necked flask were charged 108 grams (1.0 moles) meta-cresol, 40.26 grams (0.33 moles) 3,5-dimethyl phenol, 3.0 grams maleic anhydride and 70 ml. diglyme. The cresol mixture is heated under stirring and nitrogen flow to 90°C. At this temperature 86.27 grams (1.064 moles) 37% formaldehyde solution is slowly added by dropping funnel during a period of one hour. After the reflux period, water and solvent are removed via distillation, first at atmospheric pressure, then by slowing applying vacuum when the pot temperature reaches 200°C. Vacuum is applied until 30 mm Hg and a maximum temperature of 220°C is achieved. The reaction mixture is then held at this temperature and pressure for one hour before the molten resin is poured into a cooling tray.

The resin has the following characteristics:

```
Viscosity (RMW)
(7% solution in Cyclohexanone)    =    18.3
Tg                                =    130°C
Mw                                =    13,445
Mn                                =    1,988
Dissolution Rate
(AZ-312 MIF 1:1.2)                =    0.535 micron/min
```

Solution Viscosity - Relative Molecular Weight (RMW) :

The viscosity solution was prepared by dissolving 7 grams resin in 100 ml. volumetric flask using cyclohexanone solvent. The solution was filtered using a 5 micron pressure syringe filter. The viscosity was measured using a Cannon-Fenske #200 viscometer at 25°C. The relative molecular weight (RMW) was determined using the following equation:

$$Mrel = [1/C \log (\frac{n}{no}) ]^2$$

where
c = concentration of resin in g/ml.
n = viscosity of resin in cyclohexanone
no= viscosity of cyclohexanone

Dissolution Rate Procedure:

Formulations:

Dissolve 26% resin solids in Propylene Glycol Methyl Ether Acetate (PGMEA). Filter through a 0.2 um disposable Acrodisc filter.

Reference Standards:

VPN 1110 lot P7 resin produced by Hoechst Celanese Corporation. s-Resin Stock #D9922A produced by Hoechst Celanese Corporation (supplied in PGMEA).

Spin Speed Determinations for 1.6 um Films:

For each sample, spin one wafer at the following speeds: 2000, 4000 and 6000 rpm/30 sec. Bake all wafers at 90°C/30 minutes. Measure film thickness at n=1.64 and interpolate the speed required to obtain 1.6um by logarithmic (base 10) regression.

Dissolution Rate Procedure:

1. For each sample and reference, spin coat 2 wafers at the appropriate speed to obtain 1.6 um films.
2. Bake wafers at 90+/-1°C for 30 minutes.
3. Determine 5 measurements of the film thickness per wafer at 12, 3, 6 and 9 o'clock and center, in that order), in um with FTM n = 1.64.
4. Batch develop all wafers simultaneously with no agitation in AZ312 MIF (pre-diluted 1:1.2) 4 parts by volume to 1 part by volume deionized water (0.20N TMAH), for 1 minute at 25+/-0.1°C. Rinse wafers in deionized water, air dry, then bake in circulating air oven at 90°C for 2 minutes.

Molecular Weight Data (Mw and Mn):

The molecular weight of the polymers, whether weight average molecular weight, Mw, or number average molecular weight Mn, were measured by gel permeation chromatography (GPC) performed on dilute solutions of the polymer in tetrahydrofuran (THP). The catual apparatus employed consisted of Waters (Millipore Corp.) programmable automatic sampler, vacuum pump, chromatography columns with heater, and a differential refractometer connected 60cc/minute. Glass transition temperature by this method is generally defined as the point of intersection of tangent lines about the point of first inflection of the heating curve of the polymer.

Example 2

Synthesis of Meta-Cresol/3,5-Xylenol Formaldehyde Novolak Resin

Into a 500 ml. three necked flask were charged 89.78 grams (0,83 moles) meta-cresol, 60,85 grams (0.4987 moles) 3,5-xylenol, 3,0 grams maleic anhydride and 70 ml. diglyme. The cresol mixture is heated under stirring and nitrogen flow to 98°C. At this temperature 83.3 grams (1,08 moles) 37% formaldehyde solution is slowly added by dropping funnel during a period of one hour. The condensation reaction is allowed to continue for 4 hours at 90°C. After the reflux period, water and solvent are removed via distillation, first at atmospheric pressure, then by slowing applying vacuum when the pot temperature reaches 200°C. Vacuum is applied until 30 mm Hg and a maximum temperature of 220°C is achieved. The reaction is then held at this temperature and pressure for one hour before the molten resin is poured into a cooling tray.

The resin obtained has the following characteristics:

**Viscosity (RMW)**
**(7% solution in Cyclohexanone)** = 17.0
**Tg** = 126°C
**Mw** = 8,816
**Mn** = 1,238
**Dissolution Rate**
**(AZ-312 MIF 1:1.2)** = 0.014 micron/min

Example 3

Synthesis of Meta-Cresol/3.5-Xylenol Formaldehyde Novolak Resin

Into a 500 ml three necked flask were charged 108 grams (1.0 moles) meta-cresol, 40.26 grams (0.33 moles) 3,5-xylenol, 3.0 grams maleic anhydride and 70 ml, diglyme. The cresol mixture is heated under stirring and nitrogen flow to 98°C. At this temperature 83.3 grams (1.08 moles) 37% formaldehyde solution is slowly added by dropping funnel during a period of one hour. The condensation reaction is allowed to continue for 4 hours at 99°C. After the reflux period, water and solvent are removed via distillation, first at atmospheric pressure, then by slowing applying vacuum when the pot temperature reaches 200°C. Vacuum is applied until 30 mm Hg and a maximum temperature of 220°C is achieved. The reaction mixture is then held at this temperature and pressure for one hour before the molten resin is poured into a cooling tray.

The resin obtained has the following characteristics:

**Viscosity (RMW)**
**(7% solution in Cyclohexanone)** = 14.0
**Tg** = 121°C
**Mw** = 6,866
**Mn** = 1,110
**Dissolution Rate**
**(AZ-312 MIF 1;1.2)** = 0.643 micron/min.

Example 4

Synthesis of Meta-Cresol/3,5-Xylenol Formaldehyde Novolak Resin (High Mw)

Into a 500 ml three necked flask were charged 108 grams (1.0 moles) meta-cresol, 40.26 grams (0,33 moles) 3,5-xylenol, 3.0 grams maleic anhydride and 70 ml. diglyme. The cresol mixture is heated under stirring and nitrogen flow to 98°C. At this temperature 85.20 grams (1,064 moles) 37% formaldehyde solution is slowly added by dropping funnel during a period of one hour. The condensation reaction is allowed to continue for 4 hours at 98°C. After the reflux period, water and colvent are removed via distillation, first at atmospheric pressure, then by slowing applying vacuum when the pot temperature reaches 200°C. Vacuum is applied until 30 mm Hg and a maximum temperature of 220°C is achieved. The reaction mixture is then held at this temperature and pressure for one hour before the molten resin is poured into a cooling tray.

The resin obtained has the following characteristics:

```
Viscosity (RMW)
(7% solution in Cyclohexanone)    =   17.0
Tg                                =   120°C
Mw                                =   8,414
Mn                                =   1,360
Dissolution Rate
(AZ-312 MIF 1;1.2)                =   0.471 micron/min.
```

Example 5

Capping of Novolak Resin with Para-Anisoyl Chloride

Into a 1 liter flask were charged 60 grams (0.5 moles) Novolak Resin, RMW = 13.0, Mw = 5,000), 300 ml. acetone and allow to dissolve over 15-20 minutes. 5,55 grams N-Methyl Morpholine was then added into the reaction flask. 8.525 grams para Anisoyl Chloride (.05 moles 10%) was diluted with 10 ml. acetone and added to the mixture by dropping funnel over a period of one hour. The condensation reaction was allowed to stir over a period of three hours at room temperature (28-30°C). The reaction mixture was slowly added to 2 liters deionized water, a light yellow precipitate was obtained which was filtered, washed and dried in a vacuum oven at 50°C overnight.

The capped resin has the following characteristics:

| Property | Before Capping | After Capping |
|---|---|---|
| RMW | 13.0 | -- |
| Tg | 106°C | 140°C |
| Dissolution Rate (Micron/minute) | 1.122 | 0.00 |

Example 6

3,6 grams of he sensitizer of Example 9 of commonly assigned copending U.S. Patent Application Docket D-3031, 21.24 grams of the Novolak resin of Example 3 and 75.15 grams of propylene Glycol Methyl Ether Acetate were added to a 100 ml. flask and stirred at room temperature to form a solution. The photoresist solution which resulted was then filtered.

The photoresist solution was spin coated, using standard techniques, onto 4″ silicon wafers at a constant speed to obtain layers of dried photoresist film having an initial thickness of 1.29 m, as measured by Rudolf Film Thickness Monitor. The wafers were baked at 90°C for 1 minute and then exposed to UV light energy through a 365 nm filter. The resists were developed for 1 minute at 25°C, using 2.38% TMAH Developer. The dark erosion rate, or development rate, of the non-exposed resist film is generally maintained within the range of 0.001 to 0.051 $\mu$m/minute (10 to 100 Å/minute). The remaining film thicknesses were then remeasured using the Rudolf Folm Thickness Monitor to determine film loss for the particular energy does.

Photosensitivity was measured by generating a characteristic curve. The slope of the plot is the contrast.

Photospeed = 28 mJ/cm$^2$
Contrast = 1.49

Example 7

3.61 grams of the sensitizer of Example 9 of copending U.S. Patent Application Docket D-3031, 21.24 grams of the Novolak resin of Example 4 and 75.15 grams of propylene Glycol Methyl Ether Acetate were added to a 100 ml. flask and stirred at room temperature to form a solution. The photoresist solution which resulted was then filtered.

The photoresist solution was spin coated, using standard techniques, onto 4″ silicon wafers at a constant speed to obtain layers of dried photoresist film having an initial thickness of 1.0 m, as measured by a Rudolf Film Thickness Monitor. The wafers were baked at 90°C for 1 minute and then exposed to UV light energy through a 365 nm filter. The resists were developed for 1 minute at 25°C, using 2.38% TMAH Developer. The dark erosion rate, or development rate, of the non-exposed resist film is generally maintained within the range of 0.001 to 0.051 $\mu$m/minute (10 to 100 Å/minute). The remaining film thicknesses were then remeasured using the Rudolf Film Thickness Monitor to determine film loss for the particular energy dose.

Photosensitivity was measured by generating a characteristic curve. The slope of the plot is the contrast.

Photospeed = 21 mJ/cm$^2$
Contrast = 2.49

Example 8

3,61 grams of the sensitizer of Example 9 of copending U.S, Patent Application Docket D-3031, 21.24 grams of the Novolak resin of Example 2 and 75,15 grams of Proylene Glycol Methyl Ether Acetate were added to 100 mil. flask and stirred at room temperature to form a solution. The photoresist solution which resulted was then filtered.

The photoresist solution was spin coated, using standard techniques, onto 4" silicon wafers at a constant speed to obtain layers of dried photoresist film having an initial thicknes sof 1.29 m, as measured by a Rudolf Film Thickness Monitor. The wafers were baked at 90°C for 1 minute and then exposed to UV light energy through a 365 nm filter. The resists were developed for 1 minute at 25°C, using 2.38% TMAH Developer. The dark erosion rate, or development rate, of the non-exposed resist film is generally maintained within the range of 0.001 to 0.051 $\mu$m/minute (10 to 100 Å/minute). The remaining film thickness were then remeasured using the Rudolf Film Thickness Monitor to determine film loss for the particular energy dose.

Photosensitivity was measured by generating a characteristic curve. The slope of the plot is the contrast.

Photospeed = 66 mJ/cm$^2$
Contrast = 1.72

It will of course be understood that the present invention has been described above purely by way of example and that modifications of detail can be made within the scope of the invention.

The dependencies of the subsidiary claims hereinafter do not imply any limitation as to the possible combinations of the features mentioned in those claims.

## Claims

1. A process for producing a water insoluble, aqueous alkali soluable novolak resin comprising condensing with formaldehyde a mixture of from about 30 to about 99 mol percent of metacresol and from about 1 to about 50 mol percent of 3, 5 -dimethylphenol or 3,5-xylenol to obtain a novolak resin having a molecular weight of at least 5,000.

2. The process of claim 1 comprising condensing said formaldehyde with a mixture of from abou 30 to about 80 mol percent of meta-cresol, from about 20 to about 50 mol percent of 3,5-dimethylphenol or 3,5-Xylenol.

3. The process of claim 1 comprising forming an admixture of the meta-cresol, 3,5-dimethylphenol or 3,5-xylenol and a catalytic amount of an acid; heating the mixture at a temperature of from about 25°C to about 95°C with agitation; adding an aqueous solution of formaldehyde over a period of from about 1/2 hour to about 2 hours; and allowing the admixture to react to completion over a period of from about 4 hours to about 6 hours at a temperature of from about 95°C to about 100°C.

4. The process of claim 4 comprising adding an aqueous solution of from about 0.70 mol percent to about 0.85 percent formaldehyde based on the cresylic component.

5. A water insoluble, aqueous alkali soluble novolak resin obtained by condensing with formaldehyde a mixture of from about 30 to about 99 mol percent of meta-cresol and from about 1 to about 50 mol percent of 3,5-dimethylphenol or 3,5-Xylenol.

6. The novolak resin of claim 5 obtained by condensing said formaldehyde with a mixture of from about 30 to about 80 mol percent of meta-cresol, from about 20 to about 50 mol percent of 3,5-dimethylphenol or 3,5-Xylenol.

7. The novolak resin of claim 5 obtained by adding an aqueous solution of from about 0.70 mol percent to about 0.85 mol percent formaldehyde based on the cresylic component.

8. The water insoluble, aqueous alkali soluble novolak resin of claim 5 wherein from about 1 to about 10 percent of its hydroxy groups have been esterified by reacting the hydroxy groups with an organic acid group containing compound.

9. The novolak resin of claim 8 wherein said organic acid group containing compound is an organic acid chloride.

10. The novolak resin of claim 9 wherein said organic acid chloride is a sulfonyl chloride, an acetyl choride or a benzoyl chloride.

11. A process for producing a water insoluble, aqueous alkali soluble novolak resin by condensing with formaldehyde a mixture of from about 30 to about 100 mol percent of m-cresol, from about 1 to about 50 mol percent of 3,5-dimethylphenol or 3,5-Xylenol to obtain a novolak resin having a molecular weight of at least 5,000 and partially esterifying the condensation product by reacting from about 1 to about 10 percent of its hydroxy groups with an organic acid group containing compound.

12. The process of claim 11 wherein said organic acid group containing compound is an organic acid cloride.

13. The process of claim 12 wherein said organic acid chloride is a sulfonyl chloride, an acetyle chloride or a benzoyl chloride.

14. A positive photoresist composition consisting essentially of an admixture of:
   a) a photosensitive component in an amount sufficient to uniformly photosensitize the photoresist composition; and
   b) a water insoluble, aqueous alkali soluble novolak resin obtained by condensing with formaldehyde a mixture of from about 30 to about 99 mol percent of meta-cresol, from about 1 to about 50 mol percent of 3,5-dimethylphenol or 3,5-Xylenol. The novolak resin being present in the photoresist composition in an amount sufficient to form a substantially uniform photoresist composition; and
   c) a suitable solvent.

15. The photoresist composition of claim 14 wherein said photosensitive component is an ester of an alcoholic or phenolic residue and a sulfonic acid or sulfonic acid derivative.

16. The photoresist compostion of claim 14 wherein said novolak was obtained by condensing formaldehyde with a mixture of from about 30 to 80 percent of meta-cresol, from about 20 to 50 mol percent of 3,5-dimethylphenol or 3,5-Xylenol.

17. The photoresist composition of claim 14 wherein said solvent is selected from the group consisting of propylene glycol mono-alkyl ether, propylene glycol alkyl either acetate, butyl acetate, xylene, ethylene glycol monethyl ether acetate.

18. The photoresist composition of claim 14 wherein said solvent is propylene glycol monomethyl ether acetate.

19. A method for producing a semiconductor device by producing a photoresist image on a substrate by coating a suitable substrate with a positive working photoresist composition which composition consists essentially of an admixture of:

a) a photosensitive component in an amount sufficient to photosensitize the photoresist composition; and

b) a water insoluble, aqueous alkali soluble novolak resin obtained by condensing with formaldehyde a mixture of from about 30 to about 99 mol percent of meta-cresol, from about 20 to about 50 mol percent of 3,5-dimethylphenol or 3,5-Xylenol wherein the novolak resin may have its hydroxy groups partially esterified by reacting from about 1 to about 10% of the hydroxy groups with an organic acid group containing compound, the novolak resin bein present in the photoresist composition in an amount sufficient to form a substantially uniform photoresist composition; and

c) a suitable solvent; and

d) heat treating the coated substrate until substantially all of the solvent is removed; image-wise exposing the photosensitive composition; and removing the image-wise exposed areas of such composition with an aqueous alkaline developer.

20. The method of claim 19 wherein said photosensitive component is an ester of alcoholic or phenolic residue and a sulfonic acid or sulfonic acid derivative.

21. The method of claim 19 wherein said novolak was obtained by condensing formaldehyde with a mixture of from about 30 to 80 percent of meta-cresol, from about 20 to 50 mol percent of 3,5-dimethylphenol or 3,5-Xylenol.

EP 0 529 969 A1

**European Patent Office**

# EUROPEAN SEARCH REPORT

Application Number

EP 92 30 7657

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | Derwent Publications Ltd., London, GB; AN 87-018004 & JP-A-61 275 748 (SUMITOMO) 5 December 1986 * abstract * | 1-21 | G03F7/023 C08G8/24 |
| Y | EP-A-0 384 481 (CHISSO) * claim 1; example 1 * | 1-21 | |
| Y | EP-A-0 434 442 (HOECHST CELANESE) * claim 1 * | 1-21 | |
| Y | EP-A-0 239 423 (JAPAN SYNTH RUBBER) * claims 1,2,8 * | 1-21 | |
| P,A | EP-A-0 451 850 (MITSUBISHI) * page 2, line 25 - line 30; claim 1 * | 1 | |
| A | EP-A-0 196 999 (CIBA GEIGY) | 1 | |

| | | | TECHNICAL FIELDS SEARCHED (Int. Cl.5) |
|---|---|---|---|
| | | | G03F C08G |

The present search report has been drawn up for all claims

| Place of search | Date of completion of the search | Examiner |
|---|---|---|
| THE HAGUE | 27 NOVEMBER 1992 | LENTZ J.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

12